# EUROPEAN PATENT APPLICATION

(11) **EP 2 827 682 A1**
(43) Date of publication of application: **21.01.2015**
(21) Application number: 13760732.1
(22) Date of filing: 07.03.2013
(51) Int. Cl.: H05B 33/10, C23C 14/24, H01L 51/50

(54) **MANUFACTURING METHOD AND MANUFACTURING DEVICE FOR ORGANIC EL ELEMENTS**

(30) Priority: 16.03.2012 JP 2012060629
(71) Applicant: Nitto Denko Corporation, Ibaraki-shi, Osaka 567-8680 (JP)
(72) Inventor: KAKIUCHI, Ryohei, Ibaraki-shi Osaka 567-8680 (JP); YAMAMOTO, Satoru, Ibaraki-shi Osaka 567-8680 (JP)
(74) Representative: Stolmár & Partner
(86) International application number: PCT/JP2013/056317
(87) International publication number: WO 2013/137107

(57) **Abstract**

The invention allows evaporation materials discharged from evaporation sources to deposit on a substrate with a desired pattern, while eliminating the need for the conventional strip-shaped shadow mask, and enables correction of the effects due to the substrate being displaced during conveyance. In the apparatus for manufacturing an organic EL device, a first drive section rotates a roller at a specific rotational speed, thereby conveying the substrate that is in contact with the roller. This apparatus performs deposition of evaporation materials discharged from evaporation sources on the substrate with such conveyance. In this apparatus, a shielding section is driven by a second drive section so as to pivot around an axis of the roller at a specific pivot speed, thereby shielding and unshielding the substrate. The second drive section changes the pivot speed of the shielding section so that it is different from the rotational speed of the roller.

## Description

### CROSS-REFERENCE TO RELATED APPLICATION

This application claims priority to Japanese Patent Application No. 2012-060629, the disclosure of which is incorporated herein by reference in its entirety.

### FIELD

The present invention relates to a method for manufacturing an organic EL (electroluminescence) device by depositing evaporation materials vaporized from evaporation sources onto a strip-shaped substrate, and to an apparatus for manufacturing an organic EL device.

### BACKGROUND

As a method for manufacturing an organic EL device, a manufacturing method including a step of transporting a strip-shaped substrate so that the substrate is transported along a specific transportation direction, and a step of depositing evaporation materials discharged from evaporation sources onto the substrate is conventionally known (e.g., Patent Literature 1). This manufacturing method makes it possible to deposit the evaporation materials on the substrate with a desired pattern by bringing a strip-shaped shadow mask into tight surface-to-surface contact with the strip-shaped substrate and transporting the shadow mask integrally with the substrate.

### CITATION LIST

### Patent Literature

Patent Literature 1: JP 2000-183500 A

### SUMMARY

### Technical Problem

In the manufacturing method according to Patent Literature 1, a feed roller that feeds the shadow mask, a take-up roller that winds up the shadow mask, and a plurality of support rollers that support the shadow mask are provided. Accordingly, there is a general problem of an increase in the size of the apparatus. Further, in the case where the evaporation materials are intended to be deposited on the substrate with a different pattern, a complicated operation is necessary for replacement with another shadow mask (template switching), which is also a problem.

Furthermore, in such a conventional manufacturing method, the substrate is displaced during the conveyance from a specific position along the conveyance direction due to conveyance error, thermal expansion of the substrate, and other reasons, which occur during the conveyance. This can possibly make it difficult to deposit the evaporation materials onto the specific position.

The present invention has been devised in view of such circumstances described above, and an object thereof is to provide a method and an apparatus for manufacturing an organic EL device, which allow evaporation materials discharged from evaporation sources to deposit on a substrate with a desired pattern, while eliminating the need for the strip-shaped shadow mask as conventionally used, and enable correction of the effects due to the displacement of the substrate that can occur during conveyance.

### Solution to Problem

In order to solve the aforementioned problems, a method for manufacturing an organic EL device according to the present invention includes: conveying a strip-shaped substrate with the substrate being in contact with a roller and with the roller being rotated at a specific rotational speed; depositing an evaporation material on a specific portion of the substrate by discharging the evaporation material from an evaporation source; shielding the substrate using a shielding section that is configured to shield the substrate so as to prevent the deposition of the evaporation material on a portion other than the specific portion of the substrate during the deposition of the evaporation material, by causing the shielding section to pivot around an axis of the roller at a specific pivot speed in conjunction with the rotation of the roller; and adjusting a shielding position at which the shielding section shields the substrate by setting the pivot speed of the shielding section that is different from the rotational speed of the roller.

Further, the present invention further includes detecting a position of the organic EL device formed on the substrate, on the basis of a position of a patterning formed on the substrate.

In order to solve the aforementioned problems, an apparatus for manufacturing an organic EL device according to the present invention includes: a roller in contact with a strip-shaped substrate; a first drive section configured to rotationally drive the roller at a specific rotational speed; an evaporation source configured to discharge an evaporation material toward a specific portion of the substrate so as to deposit the evaporation material on the substrate; a shielding section configured to shield the substrate so as to prevent the deposition of the evaporation material on a portion other than the specific portion; and a second drive section configured to drive the shielding section so that the shielding section pivots around an axis of the roller at a specific pivot speed in conjunction with the rotation of the roller, wherein the shielding section pivots at a specific pivot speed so as to shield and unshield the substrate by being driven by the second drive section, and the second drive section changes the pivot speed of the shielding section so that the pivot speed of the shielding section is different from the rotational speed of the roller.

### Advantageous Effects of Invention

As has been described above, the present invention allows evaporation materials discharged from evaporation sources to deposit on a substrate with a desired pattern, while eliminating the need for the strip-shaped shadow mask as conventionally used, and enables correction of the displacement of the substrate that can occur during conveyance.

### BRIEF DESCRIPTION OF DRAWINGS

Fig. 1 shows a general plan view of an apparatus for manufacturing an organic EL device according to an embodiment of the present invention.
Fig. 2 shows a general front view of the apparatus for manufacturing an organic EL device according to the aforementioned embodiment.
Fig. 3 is a plan view of a main part of the apparatus for manufacturing an organic EL device according to the aforementioned embodiment.
Fig. 4 is a plan view of a main part of the apparatus for manufacturing an organic EL device according to the aforementioned embodiment.
Fig. 5 is a sectional view of a main part of the apparatus for manufacturing an organic EL device according to the aforementioned embodiment.
Fig. 6 is a front view of a shielding section according to the aforementioned embodiment.
Fig. 7 is a front view of the shielding section according to the aforementioned embodiment.
Fig. 8 is a plan view of a main part of an organic EL device manufactured by the manufacturing method according to the aforementioned embodiment.

### DESCRIPTION OF EMBODIMENTS

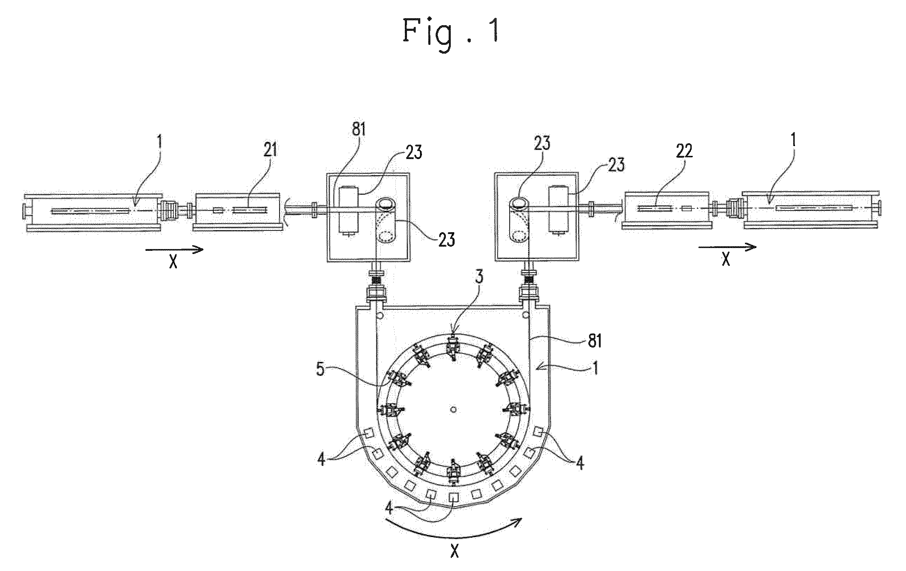

Hereinafter, embodiments of an apparatus for manufacturing an organic EL device (hereinafter may be referred to simply as "manufacturing apparatus") and a manufacturing method according to the present invention are described with reference to Fig. 1 to Fig. 8.

As shown in Fig. 1 to Fig. 7, the manufacturing apparatus according to the present invention includes a plurality of (three in the illustrated examples) vacuum chambers 1 in which a vacuum is maintained, a transporting section 2 that transports a strip-shaped substrate 81 along a specific direction (hereinafter may be referred to as "transportation direction") X so that the substrate 81 passes through the inside of the vacuum chambers 1, a plurality of can rollers 3 that are provided in intermediate portions of the conveyance path of the substrate 81 so as to be in contact with the substrate 81, a plurality of evaporation sources 4 that discharge evaporation materials toward the substrate 81, a shielding section 5 that is provided in the vicinity of each of the can rollers 3 so as to shield the substrate 81 in contact with the can roller 3 from the evaporation sources 4 at a specific position, a drive section (hereinafter referred to as "first drive section") 6 that drives the can roller 3, a drive section (hereinafter referred to as "second drive section") 7 that drives the shielding section 5, sensors 9 that detect the position of the substrate 81, and a controller (not shown) that drives and controls the transporting section 2, the first drive section, and the second drive section 7.

The plurality of vacuum chambers 1 are provided in series along the transportation direction X. Further, a vacuum generator (not shown) such as a vacuum pump is connected to each of the vacuum chambers 1, so that a vacuum is maintained inside the vacuum chamber 1.

The transporting section 2 includes a feed roller 21 that feeds the substrate 81, a take-up roller 22 that winds up the substrate 81 (specifically, an organic EL device 8 formed by deposition of the evaporation materials onto the substrate 81), and a plurality of support rollers 23 that are arranged between the feed roller 21 and the take-up roller 22 so as to support the substrate 81. The transporting section 2 transports the substrate 81 so that the substrate 81 has a portion extending linearly along the transportation direction X.

The feed roller 21 is arranged inside one of the vacuum chambers 1 on the upstream side, and the take-up roller 22 is arranged inside one of the vacuum chambers 1 on the downstream side. Further, the plurality of support rollers 23 are arranged inside the vacuum chambers 1, and are aligned in the transportation direction X. The plurality of support rollers 23 support the substrate 81 by hanging the substrate 81 thereon.

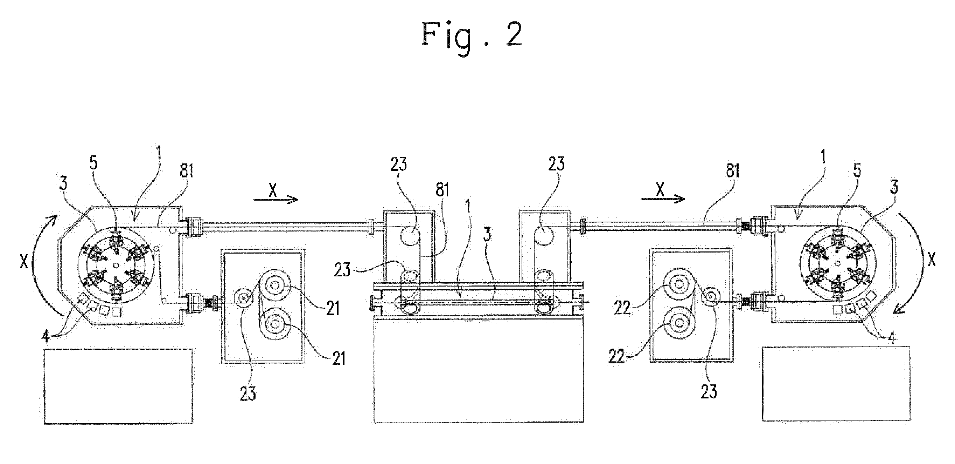

As shown in Fig. 1 and Fig. 2, the evaporation sources 4 are arranged inside the vacuum chambers 1 so as to face the substrate 81 in the radial direction of the can rollers 3.

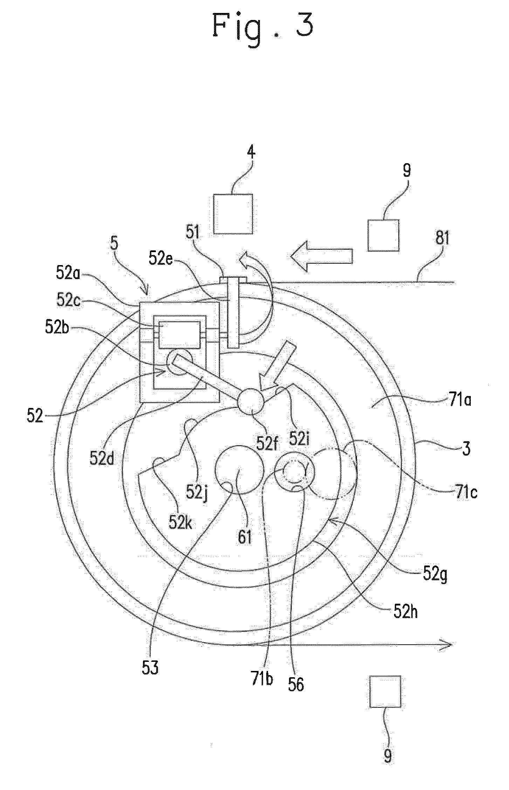

As shown in Fig. 3 to Fig. 7, the shielding section 5 includes a shield 51 that shields the substrate 81, and a switching mechanism 52 that switches the position of the shield 51 by rotationally moving the shield 51. The switching mechanism 52 switches the position of the shield 51 between a shielding position where the shield 51 is arranged between the substrate 81 and the evaporation sources 4, so as to shield the substrate 81, and an unshielding position where the shield 51 is withdrawn from between the substrate 81 and the evaporation sources 4, so as to unshield the substrate 81.

The shield 51 serves to allow certain evaporation materials discharged from the evaporation sources 4 to deposit on a specific portion where the organic EL device 8 is formed, and serves to shield the portion other than the specific portion from deposition of the evaporation materials. Here, the phrase "portion other than the specific portion" means a portion of the substrate 81 that is overlapped with the shield 51 when the shield 51 is laid on the substrate 81 for shielding.

The switching mechanism 52 includes a body 52a that is fixed to the can roller 3, a first rotor 52b that is fixed to the body 52a so as to rotate around an axis parallel to the rotational center line of the can roller 3, and a second rotor 52c that is fixed to the body 52a so as to rotate around an axis extending along a direction orthogonal to the axis of the first rotor 52b and that is driven by the first rotor 52b.

The switching mechanism 52 includes a first link 52d having one end coupled to the axis of the first rotor 52b, and a second link 52e having one end coupled to the axis of the second rotor 52c and the other end coupled to an end of the shield 51. Moreover, the switching mechanism 52 includes a cam follower 52f that is rotatably attached to the other end of the first link 52d, and a cam 52g that is in slidable contact with the cam follower 52f.

A magnetic body is provided inside each of the first rotor 52b and the second rotor 52c. Thus, with the rotation of the first rotor 52b, the magnetic body of the second rotor 52c receives a magnetic force from the magnetic body of the first rotor 52b so that the second rotor 52c rotates. The first rotor 52b and the second rotor 52c are arranged spaced apart from each other.

The cam 52g is in the form of a circular plate. The cam 52g is arranged concentrically with the rotational center of the can roller 3. However, the cam 52g is held in the vacuum chamber 1 so as not to rotate with the can roller 3.

The cam 52g has a first region 52h in which the shield 51 is maintained at the unshielding position, a second region 52i in which the shield 51 is moved from the unshielding position to the shielding position, a third region 52j in which the shield 51 is maintained at the shielding position, and a fourth region 52k in which the shield 51 is moved from the shielding position to the unshielding position.

The first region 52h has a cam surface that is arcuate in side view with a specific radius of curvature along the outer circumference of the cam 52g that is in the form of a circular plate. The second region 52i has a cam surface that is linear in side view and is inclined at a specific inclination angle. The second region 52i has one end connected to one end of the first region 52h that is arcuate.

The third region 52j has a cam surface that is arcuate in side view with a specific radius of curvature. The third region 52j is configured to have a radius of curvature that is smaller than that of the first region 52h. The third region 52j has one end connected to the other end of the second region 52i.

The fourth region 52k has a cam surface that is linear in side view and is inclined at a specific inclination angle. The inclination direction of the fourth region 52k is set opposite to that of the second region 52i. The fourth region 52k has one end connected to the other end of the third region 52j. Further, the fourth region 52k has the other end connected to the other end of the first region 52h.

The cam follower 52f is configured to move sequentially from the first region 52h to the fourth region 52k of the cam 52g.

It should be noted that, in the switching mechanism 52, the cam follower 52f is biased by a bias section (not shown) so as to be maintained in contact with one of the regions (the first region 52h to the fourth region 52k) of the cam 52g.

As shown in Fig. 3 to Fig. 5, the first drive section has a drive shaft 61 that drives the can roller 3, and a drive motor (not shown) that rotationally drives the drive shaft 61. The drive shaft 61 is inserted through a hole 3a formed at the center of the can roller 3. To an intermediate portion of the drive shaft 61, the can roller 3 is fixed. The drive shaft 61 is configured to be capable of rotationally driving the can roller 3 by the fixation of the can roller 3 thereto.

Further, the drive shaft 61 is inserted through a hole 53 formed at the center of the cam 52g of the shielding section 5. More specifically, the drive shaft 61 is inserted through a bearing 54 provided within the hole 53 at the center of the cam 52g. Thus, the drive shaft 61 is coupled to the cam 52g so as to be rotatable relatively to the cam 52g. However, since the cam 52g is fixed to a fixing member 55, the cam 52g itself does not rotate, though it allows the drive shaft 61 to rotate relatively thereto.

The drive motor is controlled by a controller so as to rotationally drive the drive shaft 61, thereby rotationally driving the can roller 3 at a specific rotational speed.

As shown in Fig. 3 to Fig. 5, the second drive section 7 includes a pivot mechanism 71 that causes the shielding section 5 to pivot around the axis of the roller, and a drive motor 72 that drives the pivot mechanism 71.

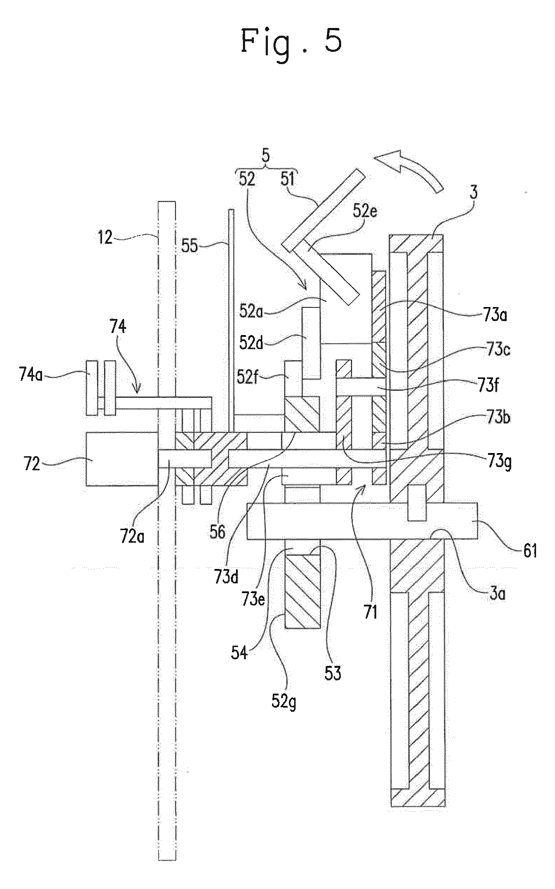

As shown in Fig. 5, the pivot mechanism 71 has a gear mechanism 73 for causing the shielding section 5 to pivot (revolve) around the axis of the can roller, and a connecting member (coupling) 74 that connects the gear mechanism 73 and the drive motor 72 to each other.

The gear mechanism 73 includes a first gear 73a that supports the shielding section, a second gear 73b connected to the drive motor 72, and a third gear 73c provided between the first gear 73a and the second gear 73b.

The first gear 73a is in the form of a plate of a ring shape (for example, a circular ring shape). In this embodiment, the first gear 73a is a ring gear. On the inner circumference of the first gear 73a, gear teeth (not shown) are formed at a specific pitch.

A spur gear is employed as the second gear 73b. A drive shaft 73d that drives the second gear 73b is inserted through a through hole 56 formed in the cam 52g. A bearing 73e is provided within the through hole 56. The drive shaft 73d of the second gear 73b is rotatably supported by the bearing 73e. The drive shaft 73d of the second gear 73b has one end connected to the drive motor 72 via the connecting member 74.

A spur gear is employed as the third gear 73c. A drive shaft 73f that drives the third gear 73c is rotatably supported by a support member 73g that is fixed to the bearing 73e of the second gear 73b. This allows the third gear 73c to transmit the driving force of the second gear 73b to the first gear 73a.

The connecting member 74 connects a drive shaft 72a of the drive motor 72 and the drive shaft 73d of the second gear 73b concentrically to each other. The connecting member 74 has an operating handle 74a for operating the connection and disconnection between the drive shaft 72a of the drive motor 72 and the drive shaft 73d of the second gear 73b. The operating handle 74a is supported by a door 12 provided on the vacuum chamber 1, outside the vacuum chamber 1.

As shown in Fig. 5, the drive motor 72 is supported by the door 12 provided on the vacuum chamber 1. The body of the drive motor 72 is supported by the door 12 of the vacuum chamber 1, outside the vacuum chamber 1. The drive shaft 72a of the drive motor 72 is passed through the door 12, and has a distal end connected to the drive shaft 73d of the second gear 73b, inside the vacuum chamber 1.

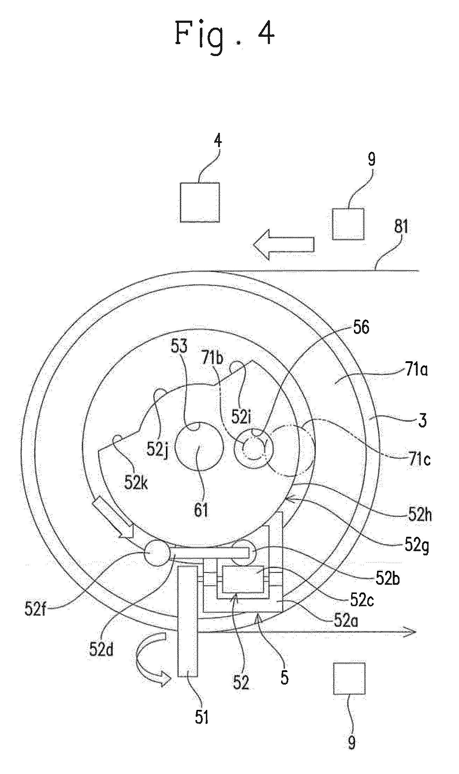

As shown in Fig. 3 and Fig. 4, the sensors 9 are arranged at positions (two places) in the vicinity of the can roller 3. The sensors 9 can detect the position of the substrate 81, the position of a specific portion of the substrate 81 where the evaporation materials are deposited, and the position of a portion of the substrate 81 where the evaporation materials are not deposited by the shielding of the shielding section (the portion other than the specific portion). That is, the sensors 9 can detect the position of the organic EL device 8 formed on the substrate 81 on the basis of the position of the patterning formed on the substrate 81. The sensors 9 are configured to transmit the data associated with the detected positions to the controller.

The controller controls the transporting section 2, the first drive section, and the second drive section 7. The controller determines whether or not the position of the substrate 81 is adequate, on the basis of the data of the substrate 81 transmitted by the sensors 9. Upon determining it to be inadequate, the controller can control the second drive section 7 so as to correct the inadequacy.

The configuration of the apparatus for manufacturing an organic EL device according to this embodiment is as described above. Next, a method for manufacturing an organic EL device according to this embodiment is described.

First, the substrate 81 is conveyed from the feed roller 21 to the take-up roller 22 of the transporting section 2. At this time, the substrate 81 is conveyed while being in contact with each of the can rollers 3 provided in the vacuum chambers 1. The can roller 3 is rotationally driven by the first drive section at a specific rotational speed. Further, the shielding section 5 is caused to pivot around the axis (that is, the drive shaft 61) of the can roller 3 by the second drive section 7 at the same speed as the rotational speed of the can roller 3.

The shielding section 5 provided in each of the can rollers 3 moves the shield 51 from the unshielding position to the shielding position, thereby shielding the substrate 81 from the evaporation sources 4.

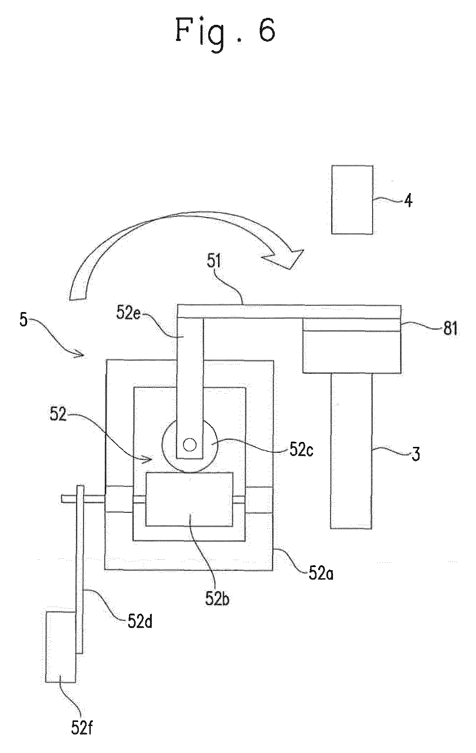

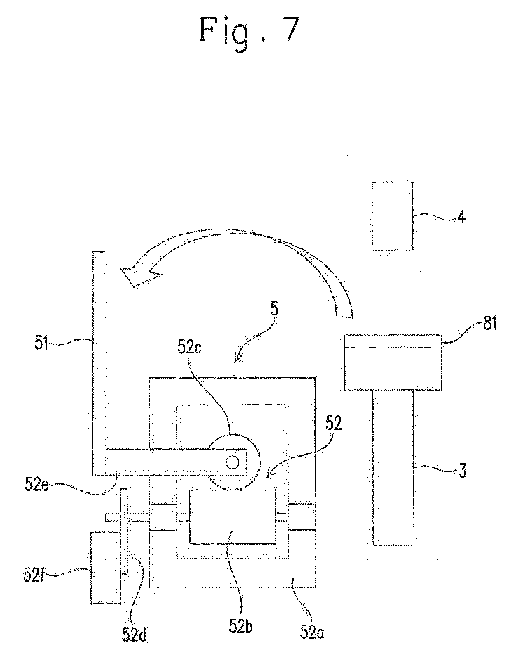

The shield 51 starts moving from the unshielding position (see Fig. 7) to the shielding position (see Fig. 6) when the cam follower 52f moves from the first region 52h to the second region 52i of the cam 52g. The cam follower 52f moves along the second region 52i to the third region 52j, thereby causing the first link 52d to pivot around the rotation axis of the first rotor 52b, in conjunction with which the first rotor 52b rotates. Further, in conjunction with the rotation of the first rotor 52b, the second rotor 52c rotates. At this time, in conjunction with the motion of the second rotor 52c, the second link 52e pivots around the rotation axis (axis) of the second rotor 52c. This causes the shield 51 to move from the unshielding position to the shielding position.

During the time when the cam follower 52f moves from the second region 52i to the third region 52j, and moves along the third region 52j, the first link 52d does not pivot. Accordingly, the shield 51 is maintained at the shielding position. Thus, the shield 51 shields the substrate 81, in which the evaporation materials are prevented from depositing on the portion other than the specific portion where the evaporation materials are to be deposited.

When the cam follower 52f moves from the third region 52j to the fourth region 52k, the shield 51 starts to be withdrawn from the shielding position to the unshielding position. The cam follower 52f moves along the fourth region 52k, thereby causing the first link 52d to pivot around the rotation axis of the first rotor 52b. At this time, the first link 52d pivots in a direction opposite to the direction in which it pivots when the cam follower 52f moves along the second region 52i. In conjunction with the pivotal motion of the first link 52d, the first rotor 52b and the second rotor 52c rotate. Furthermore, the second link 52e pivots. Thus, the shield 51 moves from the shielding position to the unshielding position.

Thereafter, the cam follower 52f moves from the fourth region 52k to the first region 52h. During the time when the cam follower 52f moves along the fourth region 52k, the first link 52d does not pivot, and thus the shield 51 is maintained at the unshielding position.

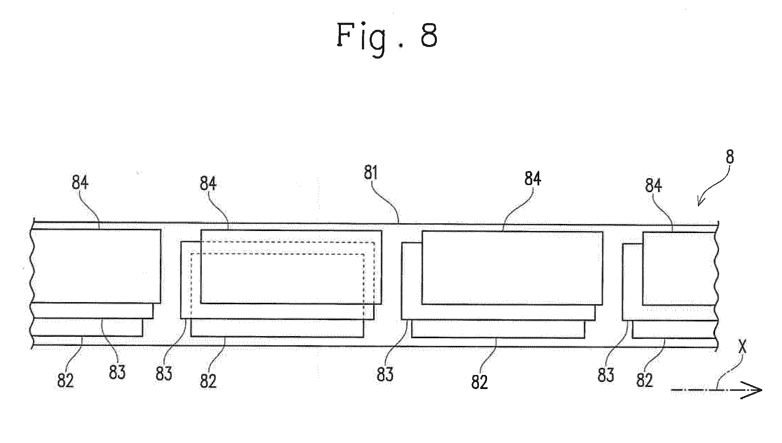

The organic EL device 8 as desired is formed on the substrate 81 by the normal operation described above. As shown in Fig. 8, the organic EL device 8 includes a lower electrode layer 82 formed by deposition of an evaporation material discharged from one of the evaporation sources 4 on one surface of the substrate 81, an organic layer 83 formed by deposition of an evaporation material further on the lower electrode layer 82, and an upper electrode layer 84 formed by deposition of an evaporation material further on the organic layer 83. The organic EL device 8 has a portion where no evaporation materials are deposited, that is, a portion where the layers 82, 83, and 84 are not provided, across the width direction of the substrate 81.

During the production of the organic EL device 8 described above, the controller monitors whether or not the organic EL device 8 is formed at a specific position of the substrate 81, on the basis of the signals from the sensors 9. Upon determining that the position of the organic EL device 8 is inadequate, for example, due to displacement of the substrate 81 caused by thermal expansion, on the basis of the signals from the sensors 9, the controller transmits a control signal to the drive motor 72 of the second drive section 7 so as to correct the inadequacy. Specifically, the controller changes the pivot speed of the shielding section 5 by changing the rotational speed of the drive motor 72 of the second drive section 7. This causes the shielding section 5 to pivot at a pivot speed different from the rotational speed of the can roller 3, so as to shield and unshield the substrate 81 at a timing different from in the normal operation. Thus, the shielding position at which the shield 51 of the shielding section 5 shields the substrate 81 is adjusted, so that the effects due to the displacement of the substrate 81 can be corrected.

In the manufacturing apparatus 1 of the organic EL device 8 and the manufacturing method thereof according to to the present invention as described above, the substrate 81 is shielded by the shielding section 5, thereby allowing the evaporation materials discharged from the evaporation sources 4 to deposit on only a specific portion of the substrate 81. Thus, the organic EL device 8 as desired can be formed on the substrate 81. Accordingly, the need for the strip-shaped shadow mask as conventionally used is eliminated. Further, in the case where the substrate 81 is not displaced during the deposition, the deposition of the evaporation materials is performed, with the pivot speed of the shielding section 5 set equal to the rotational speed of the can roller 3. In contrast, in the case where the substrate 81 is displaced, the effects due to the displacement of the substrate 81 can be corrected by changing the pivot speed of the shielding section 5 corresponding to the displacement.

Further, the sensors 9 detect the position of the organic EL device 8, on the basis of the position of the patterning formed on the substrate 81, so as to monitor the position of the organic EL device 8, thereby enabling detection of the cases where the substrate 81 is displaced and thus the position of the organic EL device 8 is inadequate.

Further, the second drive section 7 includes the pivot mechanism 71 and the drive motor 72 that drives the pivot mechanism 71, thereby enabling the shielding section 5 to be driven at a pivot speed different from the rotational speed of the can roller 3.

The method and the apparatus for manufacturing an organic EL device according to the present invention are not limited to the configurations of the aforementioned embodiments. Further, the advantageous effects of the method and the apparatus for manufacturing an organic EL device according to the present invention are not limited to the aforementioned effects. The manufacturing method and the manufacturing apparatus according to the present invention can be variously modified without departing from the gist of the present invention.

For example, an example in which the gear mechanism 73 of the second drive section 7 is composed of three gears of the first gear 73a, the second gear 73b, and the third gear 73c is mentioned in the aforementioned embodiments. However, there is no limitation to this. For example, it is also possible that the first gear 73a is directly driven by the second gear 73b without providing the third gear 73c. Each gear is not limited to a spur gear, and other various gears can be used therefor.

Further, the shielding section 5 may be caused to pivot without using the gear mechanism 73, for example, by using the first gear 73a, the second gear 73b, and a roller, instead of the third gear 73c.

### REFERENCE SIGNS LIST

1: Vacuum Chamber
2: Transporting Section
3: Can Roller
4: Evaporation Source
5: Shielding Section
7: Second Drive Section
8: Organic El Device
9: Sensor
81: Substrate
X: Transportation Direction

## Claims

1. A method for manufacturing an organic EL device, comprising:
conveying a strip-shaped substrate with the substrate being in contact with a roller and with the roller being rotated at a specific rotational speed;
depositing an evaporation material on a specific portion of the substrate by discharging the evaporation material from an evaporation source;
shielding the substrate using a shielding section that is configured to shield the substrate so as to prevent the deposition of the evaporation material on a portion other than the specific portion of the substrate during the deposition of the evaporation material, by causing the shielding section to pivot around an axis of the roller at a specific pivot speed in conjunction with the rotation of the roller; and
adjusting a shielding position at which the shielding section shields the substrate by setting the pivot speed of the shielding section that is different from the rotational speed of the roller.

2. The method for manufacturing an organic EL device according to claim 1, further comprising:
detecting a position of the organic EL device formed on the substrate, on the basis of a position of a patterning formed on the substrate.

3. An apparatus for manufacturing an organic EL device, comprising:
a roller in contact with a strip-shaped substrate;
a first drive section configured to rotationally drive the roller at a specific rotational speed;
an evaporation source configured to discharge an evaporation material toward a specific portion of the substrate so as to deposit the evaporation material on the substrate;
a shielding section configured to shield the substrate so as to prevent the deposition of the evaporation material on a portion other than the specific portion; and
a second drive section configured to drive the shielding section so that the shielding section pivots around an axis of the roller at a specific pivot speed in conjunction with the rotation of the roller, wherein
the shielding section pivots at a specific pivot speed so as to shield and unshield the substrate by being driven by the second drive section, and
the second drive section changes the pivot speed of the shielding section so that the pivot speed of the shielding section is different from the rotational speed of the roller.
